# EUROPEAN PATENT SPECIFICATION

(11) **EP 2 197 048 B1**
(45) Date of publication and mention of the grant of the patent: **26.10.2016**
(21) Application number: 08828639.8
(22) Date of filing: 28.08.2008
(51) Int. Cl.: H01L 33/38, H01L 33/50

(54) **LIGHT-EMITTING DEVICE**
LICHTEMITTIERENDE ANORDNUNG
DISPOSITIF ÉMETTANT DE LA LUMIÈRE

(30) Priority: 28.08.2007 JP 2007221864
(43) Date of publication of application: 16.06.2010
(73) Proprietor: Panasonic Intellectual Property Management Co., Ltd., Osaka 540-6207 (JP)
(72) Inventor: URANO, Youji, Kadoma-shi Osaka 571-8686 (JP); TANAKA, Kenichiro, Kadoma-shi Osaka 571-8686 (JP)
(74) Representative: Appelt, Christian W.
(86) International application number: PCT/JP2008/065417
(87) International publication number: WO 2009/028611

(56) References cited:
- WO-A2-00/60381
- WO-A2-2006/030678
- FR-A5- 2 083 868
- JP-A- 2001 237 461
- JP-A- 2003 243 726
- JP-A- 2003 243 726
- JP-A- 2003 505 857
- JP-A- 2004 221 112
- JP-A- 2007 324 411

## Description

### TECHNICAL FIELD

This invention relates to a light emitting element using LED chip (light emitting diode chip).

### BACKGROUND ART

Many studies have been widely carried out to develop light emitting element which radiates a desired colored light (e.g., white-color light) and light emitting device using the light emitting element so far. (e.g., References 1, 2, and 3) The light emitting element includes an LED chip and a color conversion layer which is made of a light-transmissive material containing phosphor. The phosphor is excited by a light emitted from the LED chip and emits a light of color different from the luminescent color of the LED.

The references 1 and 2 disclose a technique of forming a color conversion layer on one surface of the LED chip by using an ink-jet method. The reference 3 discloses a light emitting device in which an LED chip and a frame surrounding the LED chip therewith are provided on a substrate. In this light emitting device, a portion surrounded by the frame is filled with an encapsulating member made of a light-transmissive material containing a phosphor.

The reference 4 discloses a light emitting device on which an electrode grid is disposed on the p-type semiconductor layer. In this light emitting device, a fluorescent material is disposed in and over the openings of the electrode grid.

In fabrication of the light emitting elements disclosed in references 1 and 2, the color conversion member is formed directly on the LED chip by using ink-jet method. In this method, the color conversion member can be provided at its desired portion, even when the LED chip is provided at its one surface with an electrode. However, the color conversion layer may be formed with a bumpy surface when thinned, possibly causing color ununiformity.

In fabrication of the light emitting device disclosed in reference 3, thickness of the color conversion layer varies with a height gap between the LED chip and the frame mounted on the substrate. It possibly causes ununiformity in thickness of the color conversion layer.
Reference 1: Japanese unexamined patent publication 2003-46124
Reference 2: Japanese unexamined patent publication 2006-86191
Reference 3: Japanese unexamined patent publication 2005-93601
Reference 4: Japanese patent publication JP 2003-243726

### DISCLOSURE OF THE INVENTION

The present invention has been accomplished in view of the above problem, and intended to provide a light emitting element with a thinned color conversion layer, which emits a light with a minimized color ununiformity.

The light emitting element comprises an LED chip, a color conversion layer, and a frame-shaped electrode. The color conversion layer is made of a light-transmissive material containing a phosphor. The phosphor is excited by a light emitted from the LED chip to emit a light of a color having a wavelength longer than that of a luminescent color of the LED chip. The frame-shaped electrode is disposed on a top surface of the LED chip and extends along its edge. The color conversion layer is formed on the top surface of the LED chip at an area surrounded by the frame-shaped electrode. In fabrication of the light emitting element of this invention, the color conversion layer can be formed by the process of applying the light-transmissive material in suitable amount which contains a phosphor, to a portion confined by the frame-shaped electrode. According to this method, the color conversion layer can be free from a bumpy surface when thinned, which emits a light with a minimized color ununiformity.

Preferably, a partition is formed integrally with the electrode on the top surface of the LED chip to divide the area surrounded by the electrode into a plurality of sections. The color conversion layer is formed on the top surface of the LED chip at an area surrounded by the electrode and the partition.

### BRIEF DESCRIPTION OF THE DRAWINGS

FIG. 1 shows a schematic sectional view of a light emitting device using a light emitting element of the present invention, in accordance with one embodiment.
FIG. 2 shows a schematic plane view of the light emitting element for utilized in the light emitting device.
FIG 3 shows a schematic perspective view of the above light emitting element for utilized in the light emitting device.
FIG. 4 shows a schematic plane view of another example of the light emitting element for utilized in the light emitting device.
FIG. 5 shows a schematic sectional view of the example of the light emitting element in FIG. 4 for utilized in the light emitting device.
FIG. 6 shows a schematic perspective view of the example of the light emitting element in FIG. 4 for utilized in the light emitting device.

### BEST MODE FOR CARRYING OUT THE INVENTION

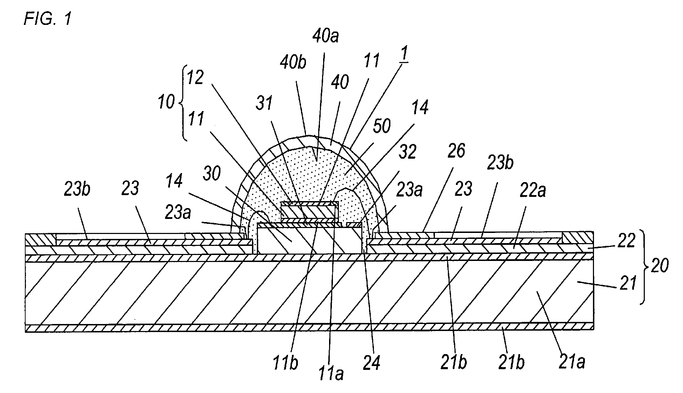

As shown in FIGS. 1, the light emitting device **1** in this embodiment comprises an LED chip **11** emitting a visible light (blue light in this embodiment), a mounting substrate **20** holding the LED chip **11,** a dome-shaped optical member **40,** an encapsulation resin **50.** The optical member **40** is disposed on the same surface of the mounting substrate **20** as that holds LED chip, as well as covering the LED chip **11** therewith. The encapsulation resin **50** is disposed in an area confined between the optical member **40** and the mounting substrate **20** so as to encapsulate the LED chip **11** therewith. The LED chip **11** is provided at its top surface (light output surface) with a color conversion layer **12.** The color conversion layer **12** is formed a light-transmissive material and contains a phosphor which is excited by a light emitted from the LED chip **11** to emit a light of a color having a wavelength longer than that of a luminescent color of the LED chip. The LED chip **11** and the color conversion layer **12** are formed to define a light emitting element **10.**

In the light emitting device **1** of this embodiment, the LED chip **11** is a GaN-based blue-light LED chip emitting blue-light. The phosphor in the color conversion layer **12** is a yellow phosphor which is excited by a blue light emitted from the LED chip **11** to emit a yellow-light. In this configuration, the blue-light is allowed to pass through the color conversion layer **12** and the encapsulation resin **50** after emitted from the LED chip **11.** The yellow-light is allowed to pass through the encapsulation resin **50** after emitted from the yellow phosphor in the color conversion layer **12.** In this configuration, the blue-light and the yellow-light are mixed with each other, then guided to a light input surface **40a** of the optical member **40,** and subsequently radiated as a white-light through a light output surface **40b** of the optical member **40.**

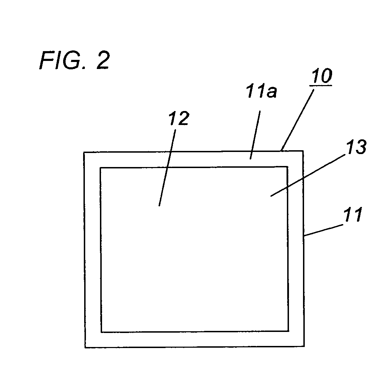

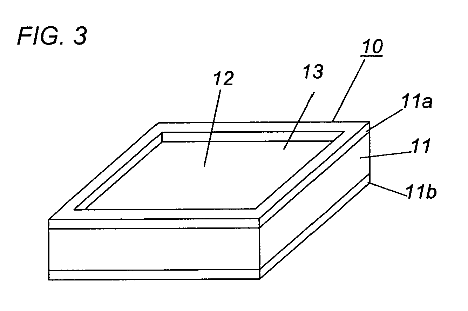

The LED chip **11** is formed at its top surface and its bottom surface with an electrode **11a,** and an electrode **11b,** respectively, as shown in FIGS. 2 and 3. Each of the electrodes **11 a, 11 b** is formed as a laminate including an upper Au film and a lower Ni film. The LED chip **11** used in this embodiment hardly leaks a blue-light from its lateral face.

The mounting substrate **20** is composed of a rectangular heat conducting plate **21** and a printed substrate **22** which is disposed to a top surface of the heat conducting plate **21** by way of a securing sheet (not shown) such as a polyolefin sheet. The printed substrate **22** is made of a rectangular flexible printed substrate, and formed at its middle position with a rectangular opening **24.** A dielectric substrate **30** having a thermal conductivity is disposed on a top surface of the heat conducting plate **21** to pass through the opening **24** of the printed substrate **22.** In this configuration, the heat generated from the LED chip **11** is allowed to be dissipated through the dielectric substrate **30** and the heat conducting plate **21,** and not introduced to the printed substrate **22.**

The heat conducting plate **21** includes a metal plate **21 a** which is made of Cu and acts as a base plate. The metal plate **21** is provided at its top and bottom surfaces with coating films **21 b** made of Au film.

The printed substrate **22** includes a dielectric plate **22a.** The dielectric plate **22a** is made of a polyimide film. The dielectric plate **22a** is provided at its top surface with a pair of patterned conductors **23** which supplies electricity to the LED chip **11,** and a resist layer **26** made of a white resin which is disposed on the patterned conductor **23.** The electrode **11 a** disposed on the LED chip **11** is electrically connected to one of the patterned conductors **23** through the bonding wire **14.** The electrode **11 b** disposed on the LED chip is connected to the patterned electrode **31** provided on the dielectric substrate **30** and electrically connected to the other of patterned conductors **23** through the bonding wire **14.** Each of the patterned conductors **23** is formed into substantially rectangular shape, and has a dimension marginally smaller than half of dimension of the dielectric plate **22a.** The dielectric plate **22a** may be formed of FR4, FR5, paper phenol, or the like.

The resist layer **26** is formed to expose one portions of the patterned conductor **23** acting as terminal portions **23a** nearby the opening **24** of the printed substrate **22.** The resist layer **26** is formed to expose other circular portions of the patterned conductor acting as circular electrodes **23b** near circumference of the printed substrate **22.** The patterned conductor **23** provided on the printed substrate **22** is made as a laminate including a Cu film, a Ni film, and an Au film which is formed at its top.

The dielectric substrate **30** is made of dielectric AIN exhibiting relatively high thermal conductivity, and formed to have a plane size larger than a chip size of the LED chip **11.** The dielectric substrate **30** is acts to relieve stress acting on the LED chip **11** due to a difference of coefficient of linear expansion between the LED chip **11** and the heat conducting plate **21.** The dielectric substrate **30** also acts to dissipate heat generated from the LED chip 11 to the heat conducting plate **21** which has a dimension larger than a chip size of the LED chip **11.** The dielectric substrate **30** can efficiently dissipate heat generated from the LED chip **11** through the dielectric substrate **30** and the heat conducting plate **21,** and can relieve stress acting on the LED chip **11** due to a difference of coefficient of linear expansion between the LED chip **11** and the heat conducting plate **21.**

The dielectric substrate **30** is formed of a dielectric AIN exhibiting relatively high thermal conductivity in this embodiment, but may be formed of a composite SiC instead of AIN. The dielectric substrate **30** is provided at its top surface with the patterned electrode **31** which is connected to the other electrode **11 b** of the LED chip **11** facing the dielectric substrate **30.** The dielectric substrate **30** is provided at its top surface with the reflecting film **32.** The reflecting film **32** is formed around a periphery of the patterned electrode **31,** and configured to reflect thereon the visible light. The reflecting film **26** enables to prevent the visible light emitted from the LED chip **11,** from being absorbed into the dielectric substrate **30,** so as to achieve a further improved light output. The patterned electrode **31** is formed of an alloy including Au and Sn (e.g., 80Au-20Sn, 70Au-30Sn). The reflecting film **32** is formed of Al, but may be formed of Ag, Ni, Au, or the like instead of Au.

In the light emitting device **1** of this embodiment, the dielectric substrate **30** is arranged to be thick enough to have a top higher than a top of the resist layer **26.** With this arrangement, the light is prevented from being absorbed into the printed substrate **22** through an inner wall of the opening **24,** after emitted from the LED chip 11 and the yellow phosphor.

The encapsulation resin **50** is made of a silicon resin, but may be made of other one such as an epoxy resin.

The optical member **40** is a dome-shaped molded article made of light-transmissive material (e.g., silicone resin). In this embodiment, the optical member **40** is a molded article made of silicone resin, enabling to minimize differences in refractive index and linear expansion coefficient between the optical member **40** and the encapsulation resin **50.** Preferably, the optical member **40** is made of an epoxy resin when the encapsulation resin **50** is an epoxy resin.

The light conversion layer **12** is formed of a phosphor and a light-transmissive material. In this embodiment, a yellow phosphor is used as the phosphor in this embodiment. A silicone resin is used as the light-transmissive material in this embodiment. The light conversion layer **12** may be formed of other light-transmissive material such as acryl resin, instead of a silicone resin.

In the light emitting device 1 in this embodiment, the color conversion layer **12** is formed of a light-transmissive material and a yellow phosphor which is excited by blue-light emitted from the LED chip **11** to emit yellow light. As being disposed on a top surface of the LED chip **11,** the color conversion layer **12** enables to enhance heat radiation by dissipating heat of the yellow phosphor contained therein toward the mounting substrate **20** through the LED chip **11.** In this light emitting device **1,** the optical member **40** is designed to have a spherical light output surface **40b.** The light emitting device has a half-sphere lens which is formed of the optical member **40** and the encapsulation resin **50,** and is possibly utilized as a point light source.

Next, explanations are given as to the light emitting element **10** which is formed of the LED chip **11** and the color conversion layer **12.**

In the light emitting device of this embodiment, a frame-shaped electrode **11 a** is disposed on the top surface of the LED chip **11** to extend along its edge. The color conversion layer **12** is formed on the top surface of the LED chip **11** inside an area **13** surrounded by the frame-shaped electrode **11 a.**

In fabrication of the light emitting element **10,** the LED chip **11** is provided at its top surface with the frame-shaped electrode **11a** and the color conversion layer **12.** The light-transmissive material containing the phosphor is applied in suitable amount on the area **13** surrounded by the frame-shaped electrode **11a** by means of dispenser or the like, so as to become the color conversion layer **12.** This fabrication method enables to provide the light emitting element **10** with a thinned color conversion layer, as well as minimizing a color ununiformity of light by improving flatness of the surface of color conversion layer **12.** This fabrication method also enables to define the thickness of the color conversion layer **12** based on thickness of the electrode **11a.**

In the light emitting device **10** of this embodiment, the LED chip **11** is provided at its top surface with the frame-shaped electrode **11a.** The color conversion layer **12** is formed on the top surface of the LED chip **11** at the area confined by the frame-shaped electrode **11 a.** The frame-shaped electrode **11 a** is disposed on a top surface of the LED chip **11** and extends along its edge. In fabrication of the color conversion layer **12** in this arrangement, the light-transmissive material containing the phosphor can be applied in suitable amount at the area surrounded by the frame-shaped electrode. The fabrication process enables to provide the thinned color conversion layer **12** with a further smoothed surface, for giving an almost evenly colored light.

Other frame member may be disposed on the electrode **11a** to define the thickness of the color conversion layer **12,** when it is difficult to define this thickness only by the electrode **11a.** Then, the color conversion layer **12** can be formed at an area defined by a frame constituted by the electrode **11a** and the frame member.

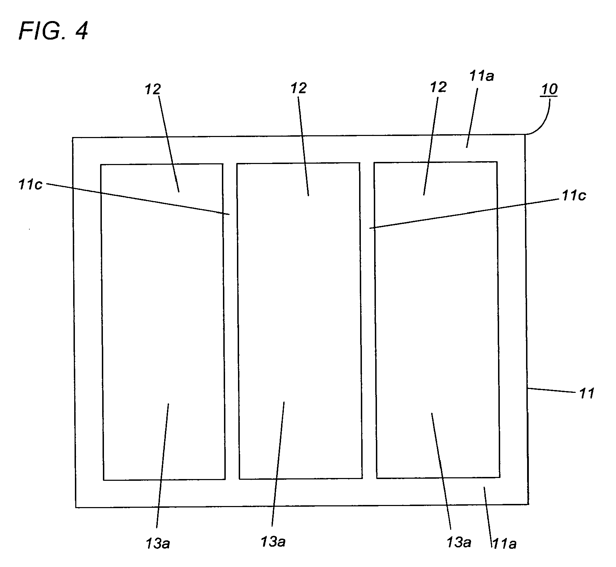

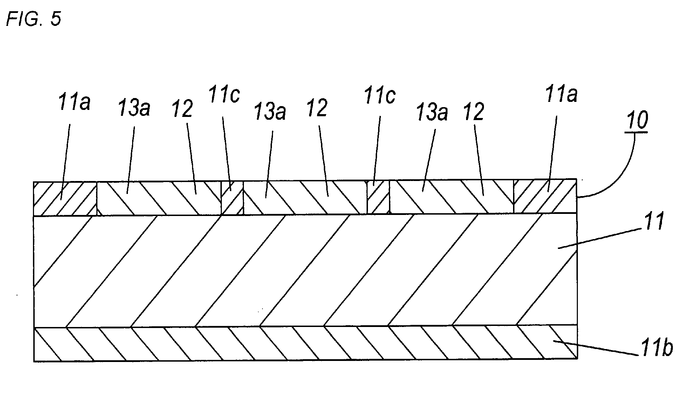

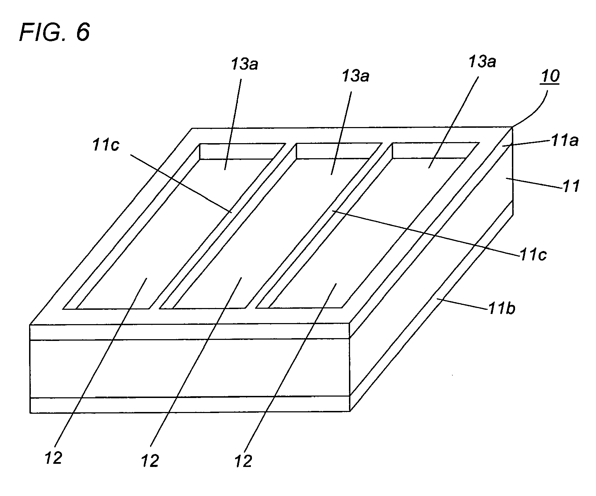

As shown in FIGS. 4 to 6, the LED chip **11** in this embodiment is provided at its top surface with a partition **11c.** The partitions are formed integrally with the frame-shaped electrode **11a** on the top surface of the LED chip **11** to divide the area surrounded by the frame-shaped electrode **11a** into a plurality of (three in this embodiment) sections **13a.** The color conversion layer **12** may be formed on the top surface of the LED chip 11 at each section **13a** so as to have a further smoothed surface. As shown in FIGS. 4 to 6, the electrode and partition are configured such that the same volumes are given at all the sections **13a** confined thereby, enabling to apply the light-transmissive material containing the phosphor at all the partitions **13a** in the same amount for easing the fabrication process.

The LED chip **11** and the phosphor in the color conversion layer **12** may be respectively formed of other materials for achieving other luminescent color combinations. For example, the phosphor in the color conversion layer **12** may be a combination of a red phosphor and a green phosphor, instead of the yellow phosphor alone, for giving a white-color light with an improved color rendition. The LED chip 11 may be selected to radiate purple-light to be combined with red-, green-, and blue-phosphors for giving a white-color light. The light emitting device includes only one light emitting element **10,** but may include a plurality of light emitting elements **10.** A plurality of the light emitting elements **10** may be individually mounted on a plurality of the dielectric substrates **30,** or mounted together on one dielectric substrate **30.**

## Claims

1. A light emitting element comprising;
an LED chip (11);
a color conversion layer (12) made of a light-transmissive material containing a phosphor; and
a frame-shaped electrode(11a) which is disposed on a top surface of said LED chip (11) and extends along its edge,
wherein said phosphor is excited by a light emitted from said LED chip (11) to emit a light of a color having a wavelength longer than that of a luminescent color of said LED chip (11),
**characterized in that**
said color conversion layer (12) is formed on said top surface of said LED chip (11) inside an area surrounded by said frame-shaped electrode (11a); or an area surrounded by said frame-shaped electrode (11a) and a frame member disposed on said electrode (11a) such that said color conversion layer (12) is confined by said frame-shaped electrode (11a), or by said frame-shaped electrode (11a) and said frame member,
and said color conversion layer (12) comprises a bumpy-free surface.

2. The light emitting element as set forth in claim 1, further comprising
a partition (11c) being formed integrally with said electrode (11a) on said top surface of said LED chip (11) to divide said area surrounded by said electrode (11a) into a plurality of sections,
wherein said color conversion layer (12) is formed on said top surface of said LED chip (11) inside an area surrounded by said electrode (11a) and said partition (11c); or an area surrounded by said electrode (11a), a frame member disposed on said electrode (11a) and said partition (11c).

## Patentansprüche

1. Lichtemittierendes Element, umfassend:
einen LED-Chip (11);
eine Farbumwandlungsschicht (12), die aus einem lichtdurchlässigen Material gefertigt ist, das einen Leuchtstoff enthält; und
eine rahmenförmige Elektrode (11a), die auf einer oberen Oberfläche des LED-Chips (11) angeordnet ist und sich entlang deren Rand erstreckt,
wobei der Leuchtstoff durch ein Licht, das von dem LED-Chip (11) emittiert wird, dazu angeregt wird, ein Licht einer Farbe zu emittieren, die eine Wellenlänge aufweist, die länger ist als diejenige einer Leuchtfarbe des LED-Chips (11),
**dadurch gekennzeichnet, dass**
die Farbumwandlungsschicht (12) auf der oberen Oberfläche des LED-Chips (11) innerhalb eines Bereichs, der durch die rahmenförmige Elektrode (11a) umgeben ist; oder eines Bereichs, der durch die rahmenförmige Elektrode (11a) und ein Rahmenelement, das auf der Elektrode (11a) angeordnet ist, umgeben ist, derart ausgebildet ist, dass die Farbumwandlungsschicht (12) durch die rahmenförmige Elektrode (11a) oder durch die rahmenförmige Elektrode (11a) und das Rahmenelement begrenzt ist, und die Farbumwandlungsschicht (12) eine beulenfreie Oberfläche umfasst.

2. Lichtemittierendes Element nach Anspruch 1, ferner umfassend:
eine Trennwand (11c), die einstückig mit der Elektrode (11a) auf der oberen Oberfläche des LED-Chips (11) ausgebildet ist, um den Bereich, der durch die Elektrode (11a) umgeben ist, in mehrere Abschnitt zu unterteilen,
wobei die Farbumwandlungsschicht (12) auf der oberen Oberfläche des LED-Chips (11) innerhalb eines Bereichs, der durch die Elektrode (11a) und die Trennwand (11c) umgeben ist; oder eines Bereichs, der durch die Elektrode (11a), ein Rahmenelement, das auf der Elektrode (11a) angeordnet ist, und die Trennwand (11c) umgeben ist, ausgebildet ist.

## Revendications

1. Élément électroluminescent qui comprend :
une puce à LED (11) ;
une couche de conversion de couleur (12) composée d'un matériau de transmission de lumière qui contient un phosphore ; et
une électrode en forme de cadre (11a) qui est disposée sur une surface supérieure de ladite puce à LED (11) et s'étend le long de son bord,
dans lequel ledit phosphore est excité par une lumière émise par ladite puce à LED (11) afin d'émettre une lumière d'une couleur qui possède une longueur d'onde supérieure à celle d'une couleur luminescente de ladite puce à LED (11),
**caractérisé en ce que**
ladite couche de conversion de couleur (12) est formée sur ladite surface supérieure de ladite puce à LED (11) à l'intérieur d'une zone entourée par ladite électrode en forme de cadre (11a) ; ou d'une zone entourée par ladite électrode en forme de cadre (11a) et d'un élément de cadre disposé sur ladite électrode (11a) de sorte que ladite couche de conversion de couleur (12) soit confinée par ladite électrode en forme de cadre (11a), ou par ladite électrode en forme de cadre (11a) et ledit élément de cadre,
et ladite couche de conversion de couleur (12) comprend une surface non bosselée.

2. Élément électroluminescent selon la revendication 1, qui comprend en outre
une séparation (11c) formée intégralement avec ladite électrode (11a) sur ladite surface supérieure de ladite puce à LED (11) afin de séparer ladite zone entourée par ladite électrode (11a) en une pluralité de sections,
dans lequel ladite couche de conversion de couleur (12) est formée sur ladite surface supérieure de ladite puce à LED (11) à l'intérieur d'une zone entourée par ladite électrode (11a) et ladite séparation (11c) ; ou d'une zone entourée par ladite électrode (11a), un élément de cadre disposé sur ladite électrode (11a), et ladite séparation (11c).
